# EUROPEAN PATENT APPLICATION

(11) **EP 4 570 401 A1**
(43) Date of publication of application: **18.06.2025**
(21) Application number: 24212563.1
(22) Date of filing: 13.11.2024
(51) Int. Cl.: B22C 9/04, B22C 9/08, B22C 9/24, B22D 27/04, B22D 27/20, C30B 11/00, C30B 29/52

(54) **SYSTEM AND METHOD OF CASTING A COMPONENT**

(30) Priority: 13.12.2023 GB 202318993
(71) Applicant: Rolls-Royce plc, London N1 9FX (GB)
(72) Inventor: Boyer, Philip C, Derby, DE24 8BJ (GB)
(74) Representative: Rolls-Royce plc

(57) **Abstract**

A system (100) for casting a component (50). The system (100) includes a base (114), a seed holder (106) extending from the base (114) and configured to receive a seed crystal (116) therein. The system (100) further includes a mould (101) for casting the component (50). The mould (101) includes a first end region (120), a second end region (122), and a principle portion (124) extending between the first end region (120) and the second end region (122). The system (100) further includes a continuator (110) fluidly communicating the first end region (120) with the second end region (122) by bypassing the principle portion (124). The system (100) further includes a furnace (115) configured to heat the mould (101). The system (100) further includes a heating block (112, 112', 112") disposed adjacent to the seed holder (106) and extending towards the continuator (110).

## Description

### FIELD

The present disclosure relates to a system and a method of casting a component e.g. that may be associated with a gas turbine engine.

### BACKGROUND

Manufacturing of gas turbine components using casting is generally known, in particular for blades that are subjected to very high temperatures. Generally, such blades may be manufactured from metals and alloys by a crystallographically oriented casting process, such as a single crystal casting process (e.g., Bridgeman process) or a directed solidification process. Such blades manufactured by crystallographically oriented casting process retain their mechanical properties even at very high temperatures. A desired crystallography may allow the blades to be more resistant to high temperature creep and achieve desired operation performance. The crystallographically oriented casting methods generally utilise a seed crystal to initiate crystal formation in the component within a mould.

In crystallographically oriented casting for manufacturing the turbine blade, a continuator communicates a region of the mould corresponding to a tip shroud of the blade to a region of the mould corresponding to a root of the blade by bypassing a region of the mould corresponding to the aerofoil of the blade. The continuator is used to manufacture the turbine blade with the same grain angle at the tip shroud as well as the root. This may improve the strength of the single crystal material with low angle grain boundaries where the crystal structure is maintained throughout the component.

However, in some applications involving crystallographically oriented casting, the continuator may experience under-cooling, particularly at the location where the continuator joins the region of the mould corresponding to the tip shroud of the blade. This means that the continuator is cooling at a faster rate than that of the mould (or main body of the casting). Due to under-cooling of the continuator, the alloy may freeze off thereby restricting the growth of the single crystal at the same angle. This may further lead to formation of high angle boundaries where the continuator joins the mould on the root and on the tip shroud. The presence of high angle boundaries in the alloy material of the turbine blade may reduce the strength of the turbine blade, especially at very high temperatures.

### SUMMARY

According to a first aspect, a system for casting a component is provided. The system includes a base. The system further includes a seed holder extending from the base and configured to receive a seed crystal therein. The system further includes a mould for casting the component. The mould includes a first end region disposed proximal to the seed holder, a second end region remote from the first end region, and a principle portion extending between the first end region and the second end region. The mould defines a cavity that is in a shape of the component. The cavity is configured to receive a molten castable material therein. The system further includes a spiral fluidly communicating the seed holder with the first end region of the mould. The system further includes a continuator fluidly communicating the first end region of the mould with the second end region of the mould by bypassing the principle portion. The system further includes a furnace configured to heat the mould. The system further includes a heating block disposed adjacent to the seed holder and extending towards the continuator. The heating block is configured to heat the continuator by absorbing heat from the furnace.

The heating of the continuator by the heating block may minimize under-cooling of the continuator which may otherwise freeze off the material of the component and restrict the growth of the single crystal at the same angle. The heat absorbed by the continuator may cause cooling of the continuator at the same rate as that of the mould. This may enhance the growth of the single crystal at the same angle. The growth of the single crystal at the same angle may prevent formation of high angle boundaries where the continuator joins the mould at the first end region and the second end region. The absence of high angle boundaries in the material of the component may increase the strength of the component, especially at very high temperatures. Therefore, the system of the present disclosure may provide a casting arrangement that casts the component with an increased strength to withstand high temperatures. The component manufactured by the system of the present disclosure may be more resistant to high temperature creep or distortion.

In cases where the component is a turbine blade or a compressor blade of a gas turbine engine, the first end region forms a tip shroud, the second end region forms a root, and the principle portion forms an aerofoil of the blade.

In some embodiments, the continuator includes a first end portion extending from the first end region of the mould, a second end portion extending from the second end region of the mould, and an elongate portion extending between the first end portion and the second end portion. The continuator may have an inlet at the first end portion to receive the seed crystal (i.e., single crystal) from the seed holder and an outlet at the second end portion to direct growth of the seed crystal to the second end region of the mould. The elongate portion directs the flow of the seed crystal from the first end portion to the second end portion, and subsequently towards the second end region of the mould.

In some embodiments, the heating block includes a top surface disposed proximal to and facing the first end portion of the continuator. The top surface is configured to heat the first end portion of the continuator. The top surface of the heating block provides a localized heating to the first end portion of the continuator which may minimize under-cooling of the continuator. The localized heating of the first end portion may maintain the cooling rate of the continuator in such a way that the continuator is cooled at the same rate as that of the mould.

In some embodiments, the first end portion of the continuator is curved and has a first radius of curvature. The top surface of the heating block is curved and has a second radius of curvature equal to the first radius of curvature of the first end portion of the continuator. This may enhance heat flow from the top surface of the heating block to the first end portion of the continuator. However, in other embodiments, the second radius of curvature may not be equal to the first radius of curvature.

In some embodiments, a distance between the top surface of the heating block and the first end portion of the continuator is between 5 mm and 10 mm. Such distance between the top surface of the heating block and the first end portion of the continuator may lead to optimal heating of the continuator by the heating block.

In some embodiments, the heating block further includes a main portion including the top surface of the heating block and a bottom surface opposite to the top surface. The main portion has a rectangular shape. The heating block further includes a support portion disposed adjacent to the main portion. The support portion extends along its length from the bottom surface of the main portion partly towards the top surface of the main portion. The support portion may provide more stability to the heating block so that the heating block is disposed firmly adjacent to the seed holder.

In some embodiments, the support portion has an arcuate shape or a triangular shape. Such a shape of the support portion may provide better stability to the heating block within the system. In some embodiments, the support portion may have a semi-circular cross section.

In some embodiments, the heating block further includes a bottom portion remote from the top surface and having an arcuate shape. The bottom portion includes a bottom surface opposite to the top surface of the heating block. The heating block further includes an elongate member extending from the bottom portion and including the top surface. The elongate member is at least partly wedge-shaped adjacent to the bottom portion. The arcuate shape of the bottom portion may provide additional stability to the heating block.

In some embodiments, a minimum distance between the heating block and the seed holder is 6 mm. Such minimum distance between the heating block and the seed holder may ensure growth of the single crystal material at the same angle, thereby minimizing or preventing the formation of high angle boundaries during the manufacturing of the component.

In some embodiments, the mould is made of a ceramic material. The ceramic material may include ceramic powder such as fused silica or zircon powder. In some embodiments, this ceramic powder may be mixed with a binder including paraffin wax and stearic acid.

In some embodiments, the heating block is made of a ceramic material or a polymeric material. The heating block may be made of a rapid prototype (RP) material selected from a group consisting of photopolymers, thermoplastics, cast ceramic powders, and sintered powdered metals.

According to a second aspect, a method of casting a component is provided. The method includes providing a base. The method further includes providing a seed holder extending from the base. The method further includes providing a mould for casting the component. The mould includes a first end region disposed proximal to the seed holder, a second end region remote from the first end region, and a principle portion extending between the first end region and the second end region. The mould defines a cavity that is in a shape of the component. The method further includes providing a spiral fluidly communicating the seed holder with the first end region of the mould. The method further includes providing a continuator fluidly communicating the first end region of the mould with the second end region of the mould by bypassing the principle portion. The method further includes providing a seed crystal within the seed holder. The method further includes introducing a molten castable material within the cavity of the mould. The method further includes providing a heating block adjacent to the seed holder and extending towards the continuator. The method further includes heating, via a furnace, the mould and the heating block. The method further includes heating, via the heating block, the continuator.

The heating of the continuator by the heating block may cause minimal under-cooling of the continuator which could otherwise restrict the growth of the single crystal at the same angle. The growth of the single crystal at the same angle may prevent formation of high angle boundaries during the casting of the component. Hence, the method of the present disclosure may provide a casting process that casts the component with an increased strength to withstand very high temperatures and retain the mechanical properties at such temperatures. The method of the present disclosure is used to manufacture the component that is more resistant to high temperature creep or distortion.

In some embodiments, the continuator includes a first end portion extending from the first end region of the mould, a second end portion extending from the second end region of the mould, and an elongate portion extending between the first end portion and the second end portion. The method further includes providing a top surface of the heating block proximal to and facing the first end portion of the continuator. The method further includes heating, via the top surface of the heating block, the first end portion of the continuator. The heating block is disposed in such a way that the top surface of the heating block provides a localized heating to the first end portion of the continuator which may minimize under-cooling of the continuator. The localized heating of the first end portion may cause the cooling of the continuator at the same rate as that of the mould.

As noted elsewhere herein, the present disclosure may relate to a gas turbine engine. Such a gas turbine engine may comprise an engine core comprising a turbine, a combustor, a compressor, and a core shaft connecting the turbine to the compressor. Such a gas turbine engine may comprise a fan (having fan blades) located upstream of the engine core.

Arrangements of the present disclosure may be particularly, although not exclusively, beneficial for fans that are driven via a gearbox. Accordingly, the gas turbine engine may comprise a gearbox that receives an input from the core shaft and outputs drive to the fan so as to drive the fan at a lower rotational speed than the core shaft. The input to the gearbox may be directly from the core shaft, or indirectly from the core shaft, for example via a spur shaft and/or gear. The core shaft may rigidly connect the turbine and the compressor, such that the turbine and compressor rotate at the same speed (with the fan rotating at a lower speed). The gearbox may be a reduction gearbox (in that the output to the fan is a lower rotational rate than the input from the core shaft). Any type of gearbox may be used.

The gas turbine engine as described herein may have any suitable general architecture. For example, the gas turbine engine may have any desired number of shafts that connect turbines and compressors, for example one, two or three shafts. Purely by way of example, the turbine connected to the core shaft may be a first turbine, the compressor connected to the core shaft may be a first compressor, and the core shaft may be a first core shaft. The engine core may further comprise a second turbine, a second compressor, and a second core shaft connecting the second turbine to the second compressor. The second turbine, second compressor, and second core shaft may be arranged to rotate at a higher rotational speed than the first core shaft.

In such an arrangement, the second compressor may be positioned axially downstream of the first compressor. The second compressor may be arranged to receive (for example directly receive, for example via a generally annular duct) flow from the first compressor.

In any gas turbine engine as described herein, a combustor may be provided axially downstream of the fan and compressor(s). For example, the combustor may be directly downstream of (for example at the exit of) the second compressor, where a second compressor is provided. By way of further example, the flow at the exit to the combustor may be provided to the inlet of the second turbine, where a second turbine is provided. The combustor may be provided upstream of the turbine(s).

The or each compressor (for example the first compressor and second compressor as described above) may comprise any number of stages, for example multiple stages. Each stage may comprise a row of rotor blades and a row of stator vanes, which may be variable stator vanes (in that their angle of incidence may be variable). The row of rotor blades and the row of stator vanes may be axially offset from each other.

The or each turbine (for example the first turbine and second turbine as described above) may comprise any number of stages, for example multiple stages. Each stage may comprise a row of rotor blades and a row of stator vanes. The row of rotor blades and the row of stator vanes may be axially offset from each other.

Gas turbine engines in accordance with the present disclosure may have any desired bypass ratio, where the bypass ratio is defined as the ratio of the mass flow rate of the flow through the bypass duct to the mass flow rate of the flow through the core at cruise conditions. The bypass duct may be substantially annular. The bypass duct may be radially outside the engine core. The radially outer surface of the bypass duct may be defined by a nacelle and/or a fan case.

Specific thrust of an engine may be defined as the net thrust of the engine divided by the total mass flow through the engine. At cruise conditions, the specific thrust of an engine described herein may be less than (or in the order of) any of the following: 110 Nkg-1s, 105 Nkg-1s, 100 Nkg-1s, 95 Nkg-1s, 90 Nkg-1s, 85 Nkg-1s or 80 Nkg-1s. The specific thrust may be in an inclusive range bounded by any two of the values in the previous sentence (i.e., the values may form upper or lower bounds), for example in the range of from 80 Nkg-1s to 100 Nkg-1s, or 85 Nkg-1s to 95 Nkg-1s. Such engines may be particularly efficient in comparison with conventional gas turbine engines.

A fan blade and/or aerofoil portion of a fan blade described herein may be manufactured from any suitable material or combination of materials. For example, at least a part of the fan blade and/or aerofoil may be manufactured at least in part from a composite, for example a metal matrix composite and/or an organic matrix composite, such as carbon fibre.

The fan of a gas turbine as described herein may have any desired number of fan blades, for example 14, 16, 18, 20, 22, 24 or 26 fan blades.

The skilled person will appreciate that except where mutually exclusive, a feature or parameter described in relation to any one of the above aspects may be applied to any other aspect. Furthermore, except where mutually exclusive, any feature or parameter described herein may be applied to any aspect and/or combined with any other feature or parameter described herein.

### BRIEF DESCRIPTION OF THE DRAWINGS

Embodiments will now be described by way of example only, with reference to the Figures, in which:
FIG. 1 is a sectional side view of a gas turbine engine;
FIG. 2 is a schematic perspective view of a component associated with a turbine of the gas turbine engine of FIG. 1;
FIG. 3 is a schematic perspective view of a system for casting the component of FIG. 2;
FIG. 4A is a sectional view of the system of FIG. 3;
FIG. 4B is a partial sectional view of the system of FIG. 3;
FIG. 5A is a schematic partial perspective view of a heating block of the system of FIG. 3;
FIG. 5B is a schematic partial perspective view of a heating block;
FIG. 5C is a schematic partial perspective view of a heating block; and
FIG. 6 is a flowchart for a method for casting the component of FIG. 2.

### DETAILED DESCRIPTION

Aspects and embodiments of the present disclosure will now be discussed with reference to the accompanying Figures. Further aspects and embodiments will be apparent to those skilled in the art.

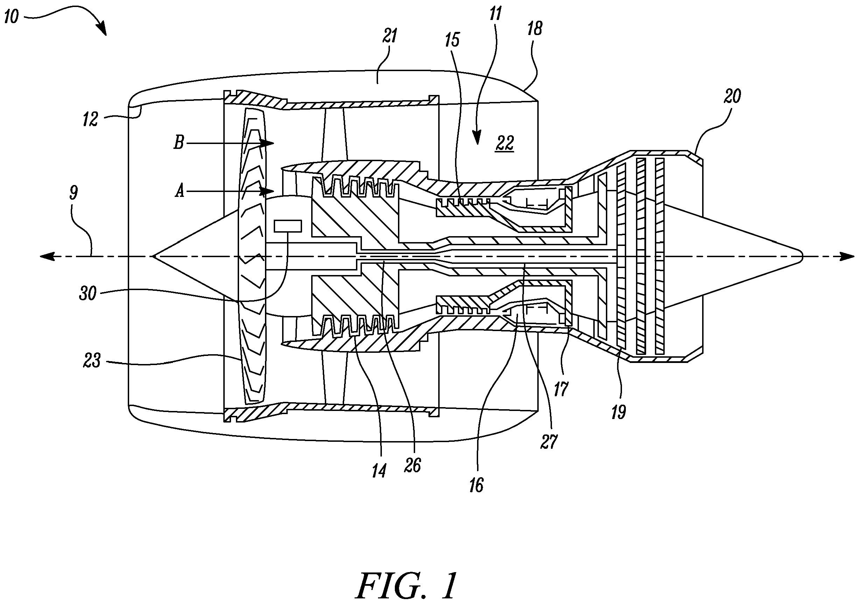

FIG. 1 illustrates a gas turbine engine 10 having a principal rotational axis 9. The engine 10 comprises an air intake 12 and a propulsive fan 23 that generates two airflows: a core airflow A and a bypass airflow B. The gas turbine engine 10 comprises an engine core 11 that receives the core airflow A. The engine core 11 comprises, in axial flow series, a low pressure compressor 14, a high pressure compressor 15, a combustion equipment 16, a high pressure turbine 17, a low pressure turbine 19, and a core exhaust nozzle 20. A nacelle 21 surrounds the gas turbine engine 10 and defines a bypass duct 22 and a bypass exhaust nozzle 18. The bypass airflow B flows through the bypass duct 22. The fan 23 is attached to and driven by the low pressure turbine 19 via a shaft 26 and an epicyclic gearbox 30.

In use, the core airflow A is accelerated and compressed by the low pressure compressor 14 and directed into the high pressure compressor 15 where further compression takes place. The compressed air exhausted from the high pressure compressor 15 is directed into the combustion equipment 16 where it is mixed with fuel and the mixture is combusted. The resultant hot combustion products then expand through, and thereby drive, the high pressure and low pressure turbines 17, 19 before being exhausted through the core exhaust nozzle 20 to provide some propulsive thrust. The high pressure turbine 17 drives the high pressure compressor 15 by a suitable interconnecting shaft 27. The fan 23 generally provides the majority of the propulsive thrust. The epicyclic gearbox 30 is a reduction gearbox.

Note that the terms "low pressure turbine" and "low pressure compressor" as used herein may be taken to mean the lowest pressure turbine stages and lowest pressure compressor stages (i.e., not including the fan 23) respectively and/or the turbine and compressor stages that are connected together by the interconnecting shaft 26 with the lowest rotational speed in the engine 10 (i.e., not including the gearbox output shaft that drives the fan 23). In some literature, the "low pressure turbine" and "low pressure compressor" referred to herein may alternatively be known as the "intermediate pressure turbine" and "intermediate pressure compressor". Where such alternative nomenclature is used, the fan 23 may be referred to as a first, or lowest pressure, compression stage.

Other gas turbine engines to which the present disclosure may be applied may have alternative configurations. For example, such engines may have an alternative number of compressors and/or turbines and/or an alternative number of interconnecting shafts. By way of further example, the gas turbine engine shown in FIG. 1 has a split flow nozzle 18, 20 meaning that the flow through the bypass duct 22 has its own nozzle 18 that is separate to and radially outside the core exhaust nozzle 20. However, this is not limiting, and any aspect of the present disclosure may also apply to engines in which the flow through the bypass duct 22 and the flow through the core 11 are mixed, or combined, before (or upstream of) a single nozzle, which may be referred to as a mixed flow nozzle. One or both nozzles (whether mixed or split flow) may have a fixed or variable area. Whilst the described example relates to a turbofan engine, the disclosure may apply, for example, to any type of gas turbine engine, such as an open rotor (in which the fan stage is not surrounded by a nacelle) or turboprop engine, for example. In some arrangements, the gas turbine engine 10 may not comprise a gearbox 30.

The geometry of the gas turbine engine 10, and components thereof, is defined by a conventional axis system, comprising an axial direction (which is aligned with the rotational axis 9), a radial direction (in the bottom-to-top direction in FIG. 1), and a circumferential direction (perpendicular to the page in the FIG. 1 view). The axial, radial, and circumferential directions are mutually perpendicular.

In addition, the present disclosure is equally applicable to aero gas turbine engines, marine gas turbine engines, and land-based gas turbine engines.

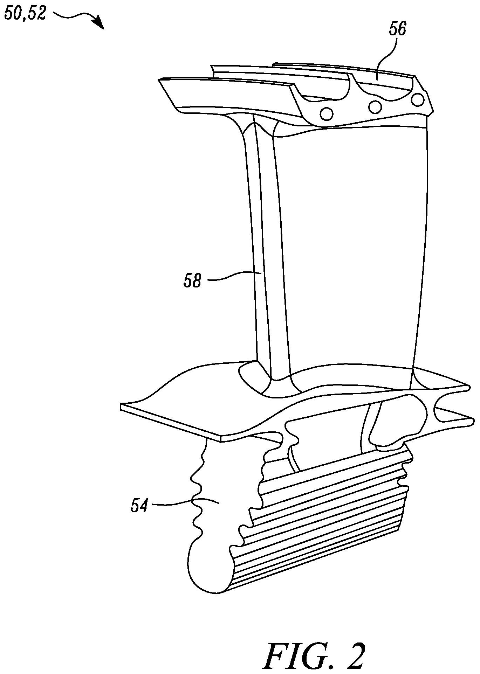

**FIG. 2** shows a perspective view of a component 50 associated with the gas turbine engine 10 (see FIG. 1). In the illustrated embodiment of FIG. 2, the component 50 is a blade 52 of the gas turbine engine 10. The blade 52 may be associated with any of the turbines 17, 19 (see FIG. 1). In other embodiments, the component 50 may include any other article, without any limitations. The component 50 is embodied as a single crystal component herein. Further, the component 50 may include a desired or predetermined crystallography.

The blade 52 includes a root 54, a tip shroud 56, and an aerofoil 58 extending between the root 54 and the tip shroud 56. The root 54 is arranged to couple the blade 52 to a rotor (not shown) for rotation about the principal rotational axis 9 of the gas turbine engine 10 (shown in FIG. 1). The tip shroud 56 is radially spaced apart from the root 54 to locate the aerofoil 58 therebetween.

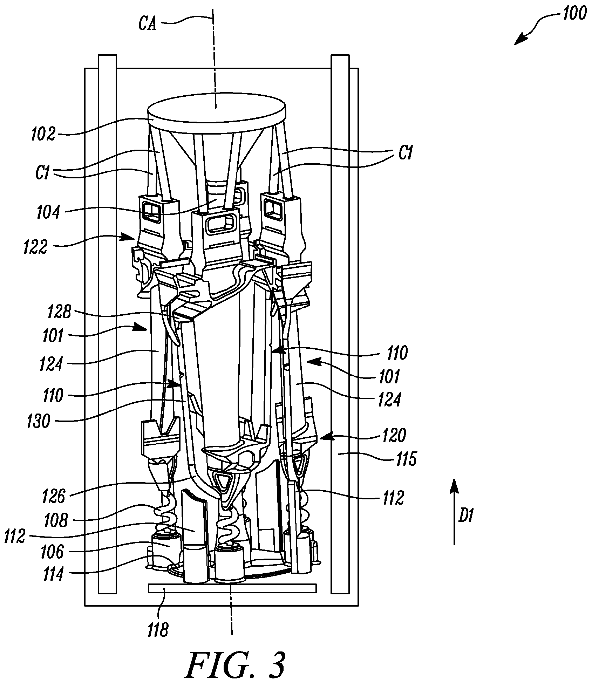

**FIG. 3** is a schematic perspective view of a system 100 for casting the component 50 shown in FIG. 2, according to an embodiment of the present disclosure. The system 100 is an arrangement for investment casting process to simultaneously manufacture multiple cast components (i.e., a plurality of components 50) using directional solidification.

The system 100 includes a pouring cup 102 into which a molten castable material is poured. For casting the blade 52 (shown in FIG. 2), the molten castable material may be a Nickel alloy. The pouring cup 102 sits on a support column 104 having a central axis CA. A plurality of feed channels C1 extend radially around the centrally arranged cup 102 to a top end of each mould 101. The molten castable material poured into the cup 102 flows along the feed channels C1 and into the respective moulds 101.

In the illustrated embodiment of FIG. 3, the system 100 includes four moulds 101 (one of which is obstructed from view in FIG. 3). Each of the four moulds 101 is associated with a corresponding seed holder 106, a spiral 108, a continuator 110, and a heating block 112. However, for descriptive purposes, the system 100 will be described hereinafter in greater detail by referring to a single mould 101, a single seed holder 106, a single spiral 108, a single continuator 110, and a single heating block 112.

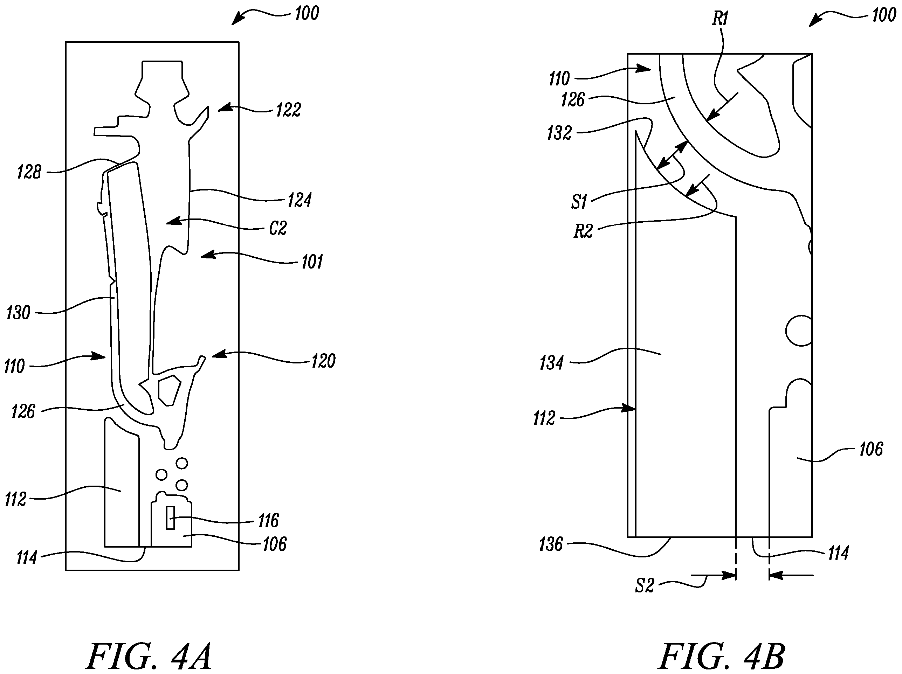

**FIG. 4A** is a sectional view of the system 100, according to an embodiment of the present disclosure. **FIG. 4B** is a partial sectional view of the system 100, wherein some parts are not shown for illustrative purposes. A portion of the mould 101 is not shown in FIG. 4B for illustrative purposes. Referring to FIGS. 3 to 4B, the system 100 includes the mould 101 for casting the component 50. The mould 101 defines a cavity C2 that is in a shape of the component 50. The cavity C2 is configured to receive the molten castable material therein.

The mould 101 is known to be made using a "lost pattern" or "lost wax" process. A low melting point material, for example wax, is shaped to form a desired shape of the component 50 (shown in FIG. 2) to be moulded. This wax model or "wax pattern" is then coated with a refractory material having a melting point higher than that of the metal or alloy to be cast. Typically, the refractory material is a slurry containing particles of a ceramic material. Once applied to the pattern, the slurry is baked to form a hard shell around the pattern. The pattern can then be removed from the shell, for example, by melting and pouring away. A cavity (i.e., the cavity C2 shown in FIG. 4A) remains in the shell and defines the shape of the component 50 to be moulded. In some embodiments, the mould 101 is made of a ceramic material.

The system 100 includes a base 114 and the seed holder 106 extending from the base 114 and configured to receive a seed crystal 116 therein. The mould 101 includes a first end region 120 disposed proximal to the seed holder 106, a second end region 122 remote from the first end region 120, and a principle portion 124 extending between the first end region 120 and the second end region 122. The system 100 further includes a chill plate 118 adjacent to the base 114 and opposite to the seed holder 106. The chill plate 118 is maintained generally at a temperature below the melting point of the molten castable material, thereby creating a temperature gradient from the first end region 120 to the second end region 122.

The system 100 further includes a furnace 115 configured to heat the mould 101. The furnace 115 encircles the mould 101 and the cup 102. The furnace 115 may be a twin zone furnace, a single zone furnace, or a super smallbore furnace. Typically, after the mould 101 is filled with the molten castable material, the mould 101 and the associated assembly is drawn in a controlled manner out of the furnace 115 in a direction D1 to ensure directional solidification from the first end region 120 of the mould 101 to the second end region 122 of the mould 101. The first end region 120 forms the tip shroud 56, the second end region 122 forms the root 54, and the principle portion 124 forms the aerofoil 58 of the blade 52 (shown in FIG. 2).

The seed crystal 116 is used to initiate crystal forming to manufacture the component 50. Specifically, after preheating and degassing, the mould 101 may be ready to receive the seed crystal 116 and a supply of molten castable material to form the component 50 (shown in FIG. 2) as a single crystal structure. Therefore, to cast the component 50 of the single crystal, the seed crystal 116 is incorporated onto the wax pattern to nucleate and/or to allow only one grain to grow into the component 50. The seed crystal 116 includes a primary growth direction (not shown). The primary growth direction is an axial direction. The seed crystal 116 also includes a secondary growth direction (not shown). The secondary growth direction is an azimuthal direction. The primary growth direction and the secondary growth direction may be determined from two fundamental Euler angles.

In some embodiments, the seed crystal 116 may have the same composition as that of the molten castable material. In some embodiments, the seed crystal 116 may include a Nickel based superalloy.

The mould 101 further includes the spiral 108 fluidly communicating the seed holder 106 with the first end region 120 of the mould 101. The spiral 108 essentially fluidly communicates the seed holder 106 with the first end region 120 of the mould 101 to effectively filter spurious grains from growing into the component 50. In other words, the spiral 108 may restrict multi-grain solidification front such that only one grain can grow out of the spiral 108 and continue to grow to the full length of the component 50.

The chill plate 118 may be adapted to cool the seed crystal 116 and the first end region 120 of the mould 101 so as to assist in progressive solidification of the molten castable material from the seed crystal 116 towards the second end region 122 of the mould 101, i.e., in the direction D1. The temperature of the chill plate 118 is preferably maintained such that the growth of dendrites begins proximal to the first end region 120 and distal to the second end region 122 of the mould 101, and the solidification front travels upward along the direction D1 towards the second end region 122 of the mould 101.

The system 100 further includes the continuator 110 fluidly communicating the first end region 120 of the mould 101 with the second end region 122 of the mould 101 by bypassing the principle portion 124. The continuator 110 includes a first end portion 126 extending from the first end region 120 of the mould 101, a second end portion 128 extending from the second end region 122 of the mould 101, and an elongate portion 130 extending between the first end portion 126 and the second end portion 128. In some embodiments, the first end portion 126 of the continuator 110 is curved and has a first radius of curvature R1 (shown in FIG. 4B).

The continuator 110 may have an inlet (not shown) at the first end portion 126 to receive the seed crystal 116 (i.e., single crystal) from the seed holder 106 and an outlet (not shown) at the second end portion 128 to direct growth of the seed crystal 116 to the second end region 122 of the mould 101. The elongate portion 130 directs the flow of the seed crystal 116 from the first end portion 126 to the second end portion 128, and subsequently towards the second end region 122 of the mould 101.

The system 100 further includes the heating block 112 disposed adjacent to the seed holder 106 and extending towards the continuator 110. In some embodiments, the heating block 112 is made of a ceramic material or a polymeric material. The heating block 112 may be made of a rapid prototype (RP) material selected from a group consisting of photopolymers, thermoplastics, cast ceramic powders, and sintered powdered metals. In some embodiments, the heating block 112 may be made of wax. The furnace 115 is further configured to heat the mould 101 as well as the heating block 112. The heating block 112 is configured to heat the continuator 110 by absorbing heat from the furnace 115.

The heating of the continuator 110 by the heating block 112 may minimize under-cooling of the continuator 110 which may otherwise freeze off the material of the component 50 and restrict the growth of the single crystal at the same angle. The heat absorbed by the continuator 110 may cause cooling of the continuator 110 at the same rate as that of the mould 101. This may enhance the growth of the single crystal at the same angle. The growth of the single crystal at the same angle may prevent formation of high angle boundaries where the continuator 110 joins the mould 101 at the first end region 120 and the second end region 122. The absence of high angle boundaries in the material of the component 50 may increase the strength of the component 50, especially at very high temperatures. Therefore, the system 100 may provide a casting arrangement so as to cast the component 50 with an increased strength to withstand high temperatures. The component 50 manufactured by the system 100 may be more resistant to high temperature creep or distortion.

In some embodiments, the heating block 112 includes a top surface 132 (shown in FIG. 4B) disposed proximal to and facing the first end portion 126 of the continuator 110. The top surface 132 is configured to heat the first end portion 126 of the continuator 110. The top surface 132 of the heating block 112 provides a localized heating to the first end portion 126 of the continuator 110 which may minimize under-cooling of the continuator 110. The localized heating of the first end portion 126 may maintain the cooling rate of the continuator 110 in such a way that the continuator 110 is cooled at the same rate as that of the mould 101.

In some embodiments, the top surface 132 of the heating block 112 is curved and has a second radius of curvature R2 equal to the first radius of curvature R1 of the first end portion 126 of the continuator 110. This may enhance heat flow from the top surface 132 of the heating block 112 to the first end portion 126 of the continuator 110. However, in other embodiments, the second radius of curvature R2 may not be equal to the first radius of curvature R1.

In some embodiments, a distance S1 (shown in FIG. 4B) between the top surface 132 of the heating block 112 and the first end portion 126 of the continuator 110 is between 5 mm and 10 mm. Such distance S1 between the top surface 132 of the heating block 112 and the first end portion 126 of the continuator 110 may lead to optimal heating of the continuator 110 by the heating block 112.

In some embodiments, a minimum distance S2 between the heating block 112 and the seed holder 106 is 6 mm. Such minimum distance S2 between the heating block 112 and the seed holder 106 may ensure growth of the single crystal material at the same angle, thereby minimizing or preventing the formation of high angle boundaries during the manufacturing of the component 50.

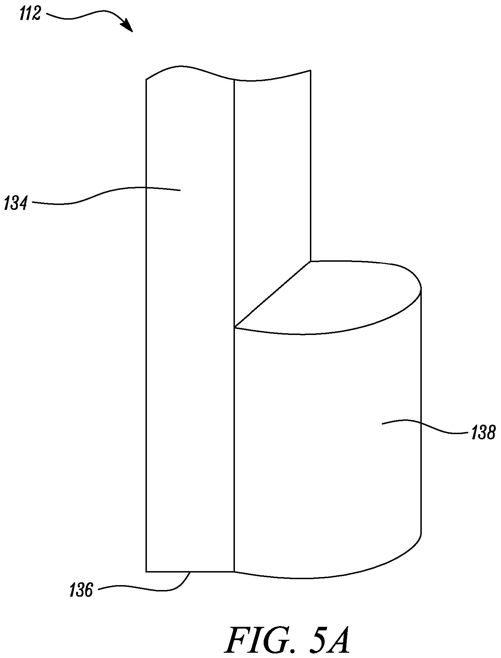

FIG. 5A is a schematic partial perspective view of the heating block 112 of the system 100 of FIGS. 3 and 4A, according to an embodiment of the present disclosure. The heating block 112 includes a main portion 134 including the top surface 132 of the heating block 112. The main portion 134 further includes a bottom surface 136 opposite to the top surface 132. The bottom surface 136 is proximal to the base 114 and distal to the first end portion 126 of the mould 101.

The heating block 112 further includes a support portion 138 disposed adjacent to the main portion 134. The support portion 138 extends along its length from the bottom surface 136 of the main portion 134 partly towards the top surface 132 of the main portion 134. The support portion 138 may provide more stability to the heating block 112 so that the heating block 112 is disposed firmly adjacent to the seed holder 106. In some embodiments, the support portion 138 has an arcuate shape or a triangular shape. Such a shape of the support portion 138 may provide better stability to the heating block 112 within the system 100. In the illustrated embodiment of FIG. 5A, the support portion 138 has a semi-circular cross section and has a hemi-cylindrical shape. In some other embodiments, the support portion 138 may have a trapezoidal shape and a trapezoidal cross section.

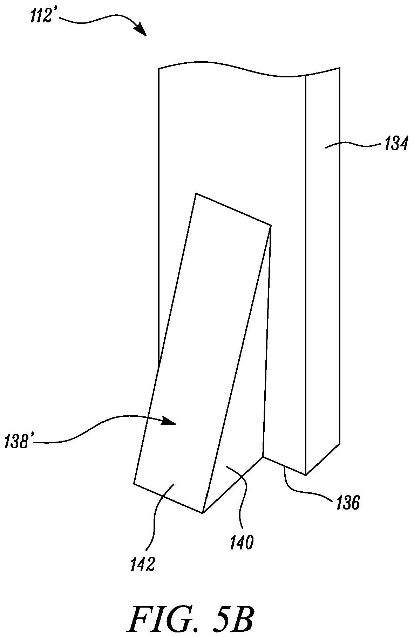

**FIG. 5B** is a schematic partial perspective view of a heating block 112', according to another embodiment of the present disclosure. The heating block 112' is substantially similar to the heating block 112 shown in FIG. 5A, with common components being referred to by same numerals. However, geometry of the heating block 112' slightly differs than that of the heating block 112. The heating block 112' includes a support portion 138' (instead of the support portion 138 shown in FIG. 5A) disposed adjacent to the main portion 134. The support portion 138' includes a pair of opposing side surfaces 140 (only one shown in FIG. 5B), a ramp 142 disposed between and extending along the pair of opposing side surfaces 140. The support portion 138' further includes a base surface (obstructed in view of FIG. 5B) adjacent to the bottom surface 136 of the main portion 134. The base surface has a rectangular (or polygonal) cross section.

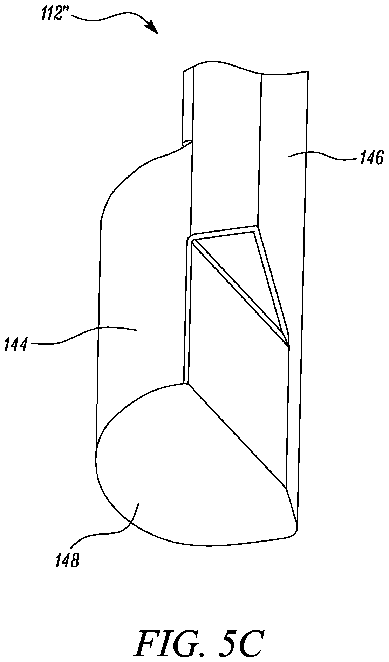

**FIG. 5C** is a schematic partial perspective view of a heating block 112", according to another embodiment of the present disclosure. The heating block 112" is functionally equivalent to the heating block 112 shown in FIG. 5A. However, the heating block 112" is geometrically different than the heating block 112'.

The heating block 112" includes a bottom portion 144 remote from the top surface 132 and having an arcuate shape. The arcuate shape of the bottom portion 144 may provide additional stability to the heating block 112". The bottom portion 144 includes a bottom surface 148 (geometrically different than the bottom surface 136 shown in FIG. 5A) opposite to the top surface 132 of the heating block 112". The heating block 112" further includes an elongate member 146 extending from the bottom portion 144 and including the top surface 132. The elongate member 146 is at least partly wedge-shaped adjacent to the bottom portion 144.

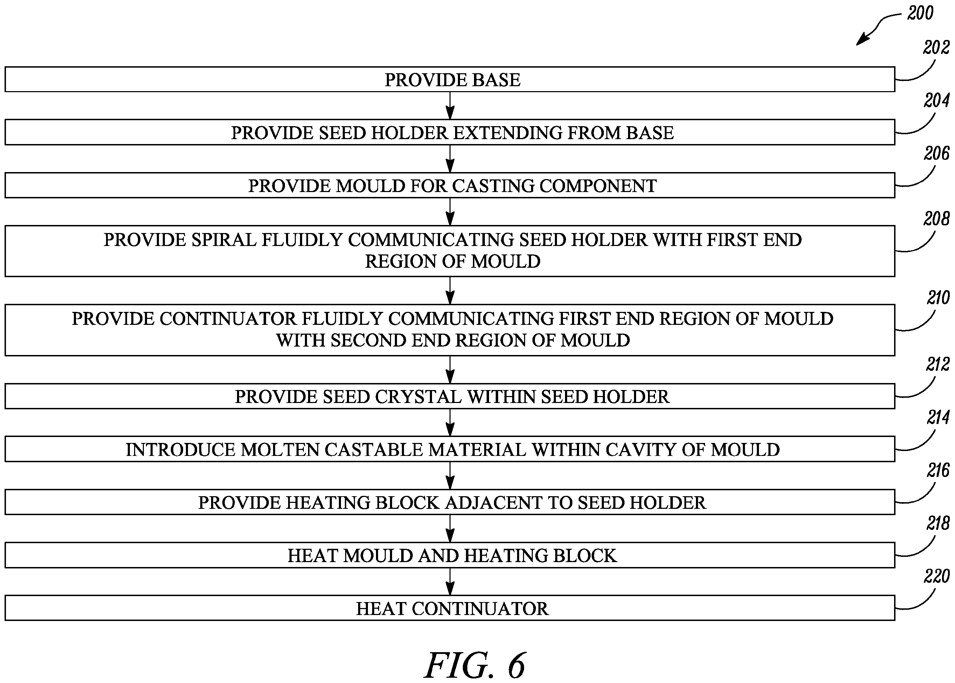

**FIG. 6** is a flowchart for a method 200 of casting the component 50 (shown in FIG. 2), according to an embodiment of the present disclosure. In other words, the component 50 of the gas turbine engine 10 (shown in FIG. 1) is manufactured according to the method 200.

Referring to FIGS. 2 to 6, at step 202, the method 200 includes providing a base 114 (shown in FIG. 3). At step 204, the method 200 includes providing the seed holder 106 extending from the base 114. At step 206, the method 200 includes providing the mould 101 for casting the component 50. At step 208, the method 200 includes providing the spiral 108 fluidly communicating the seed holder 106 with the first end region 120 of the mould 101.

At step 210, the method 200 includes providing the continuator 110 fluidly communicating the first end region 120 of the mould 101 with the second end region 122 of the mould 101 by bypassing the principle portion 124. At step 212, the method 200 includes providing the seed crystal 116 within the seed holder 106. At step 214, the method 200 includes introducing the molten castable material within the cavity C2 (shown in FIG. 4A) of the mould 101.

At step 216, the method 200 includes providing the heating block 112 adjacent to the seed holder 106 and extending towards the continuator 110. The method 200 further includes providing the top surface 132 of the heating block 112 proximal to and facing the first end portion 126 of the continuator 110. At step 218, the method 200 includes heating, via the furnace 115, the mould 101 and the heating block 112. At step 220, the method 200 includes heating, via the heating block 112, the continuator 110. The method 200 further includes heating, via the top surface 132 of the heating block 112, the first end portion 126 of the continuator 110.

During manufacturing of the component 50, the method 200 may cause the growth of the single crystal at the same angle and, therefore, prevent formation of high angle boundaries. Hence, the method 200 may provide a casting process so as to cast the component 50 with an increased strength to withstand very high temperatures and retain the mechanical properties at such temperatures. The method 200 is used to manufacture the component 50 that is more resistant to high temperature creep or distortion.

It will be understood that the invention is not limited to the embodiments above described and various modifications and improvements can be made without departing from the concepts described herein. Except where mutually exclusive, any of the features may be employed separately or in combination with any other features and the disclosure extends to and includes all combinations and sub-combinations of one or more features described herein.

## Claims

1. A system (100) for casting a component (50), the system (100) comprising:
a base (114);
a seed holder (106) extending from the base (114) and configured to receive a seed crystal (116) therein;
a mould (101) for casting the component (50), the mould (101) comprising a first end region (120) disposed proximal to the seed holder (106), a second end region (122) remote from the first end region (120), and a principle portion (124) extending between the first end region (120) and the second end region (122), the mould (101) defining a cavity (C2) that is in a shape of the component (50), wherein the cavity (C2) is configured to receive a molten castable material therein;
a spiral (108) fluidly communicating the seed holder (106) with the first end region (120) of the mould (101);
a continuator (110) fluidly communicating the first end region (120) of the mould (101) with the second end region (122) of the mould (101) by bypassing the principle portion (124);
a furnace (115) configured to heat the mould (101); and
a heating block (112, 112', 112") disposed adjacent to the seed holder (106) and extending towards the continuator (110), wherein the heating block (112, 112'. 112") is configured to heat the continuator (110) by absorbing heat from the furnace (115).

2. The system (100) of claim 1, wherein the continuator (110) comprises a first end portion (126) extending from the first end region (120) of the mould (101), a second end portion (128) extending from the second end region (122) of the mould (101), and an elongate portion (130) extending between the first end portion (126) and the second end portion (128).

3. The system (100) of claim 2, wherein the heating block (112, 112', 112") comprises a top surface (132) disposed proximal to and facing the first end portion (126) of the continuator (110), and wherein the top surface (132) is configured to heat the first end portion (126) of the continuator (110).

4. The system (100) of claim 3, wherein the first end portion (126) of the continuator (110) is curved and has a first radius of curvature (R1), and wherein the top surface (132) of the heating block (112, 112', 112") is curved and has a second radius of curvature (R2) equal to the first radius of curvature (R1) of the first end portion (126) of the continuator (110).

5. The system (100) of claim 3 or 4, wherein a distance (S1) between the top surface (132) of the heating block (112, 112', 112") and the first end portion (126) of the continuator (110) is between 5 mm and 10 mm.

6. The system (100) of any one of claims 3 to 5, wherein the heating block (112, 112') further comprises:
a main portion (134) comprising the top surface (132) of the heating block (112, 112') and a bottom surface (136) opposite to the top surface (132), the main portion (134) having a rectangular shape; and
a support portion (138, 138') disposed adjacent to the main portion (134), wherein the support portion (138) extends along its length from the bottom surface (136) of the main portion (134) partly towards the top surface (132) of the main portion (134).

7. The system (100) of claim 6, wherein the support portion (138, 138') has an arcuate shape or a triangular shape.

8. The system (100) of any one of claims 3 to 5, wherein the heating block (112") further comprises:
a bottom portion (144) remote from the top surface (132) and having an arcuate shape, the bottom portion (144) comprising a bottom surface (148) opposite to the top surface (132) of the heating block (112"); and
an elongate member (146) extending from the bottom portion (144) and comprising the top surface (132), wherein the elongate member (146) is at least partly wedge-shaped adjacent to the bottom portion (144).

9. The system (100) of claim 3 or 4, wherein a minimum distance (S2) between the heating block (112, 112', 112") and the seed holder (106) is 6 mm.

10. The system (100) of any preceding claim, wherein the mould (101) is made of a ceramic material.

11. The system (100) of any preceding claim, wherein the heating block (112, 112', 112") is made of a ceramic material or a polymeric material.

12. A method (200) of casting a component (50), the method (200) comprising:
providing a base (114);
providing a seed holder (106) extending from the base (114);
providing a mould (101) for casting the component (50), the mould (101) comprising a first end region (120) disposed proximal to the seed holder (106), a second end region (122) remote from the first end region (120), and a principle portion (124) extending between the first end region (120) and the second end region (122), the mould (101) defining a cavity (C2) that is in a shape of the component (50);
providing a spiral (108) fluidly communicating the seed holder (106) with the first end region (120) of the mould (101);
providing a continuator (110) fluidly communicating the first end region (120) of the mould (101) with the second end region (122) of the mould (101) by bypassing the principle portion (124);
providing a seed crystal (116) within the seed holder (106);
introducing a molten castable material within the cavity (C2) of the mould (101);
providing a heating block (112, 112', 112") adjacent to the seed holder (106) and extending towards the continuator (110);
heating, via a furnace (115), the mould (101) and the heating block (112, 112', 112"); and
heating, via the heating block (112, 112', 112"), the continuator (110).

13. The method (200) of claim 12, wherein the continuator (110) comprises a first end portion (126) extending from the first end region (120) of the mould (101), a second end portion (128) extending from the second end region (122) of the mould (101), and an elongate portion (130) extending between the first end portion (126) and the second end portion (128), and wherein the method (200) further comprises:
providing a top surface (132) of the heating block (112, 112', 112") proximal to and facing the first end portion (126) of the continuator (110);
heating, via the top surface (132) of the heating block (112, 112', 112"), the first end portion (126) of the continuator (110).
